# EUROPEAN PATENT APPLICATION

(11) **EP 4 572 542 A1**
(43) Date of publication of application: **18.06.2025**
(21) Application number: 23216693.4
(22) Date of filing: 14.12.2023
(51) Int. Cl.: H05K 5/00, H05K 5/03

(54) **COVER ARRANGEMENT**

(71) Applicant: ABB SCHWEIZ AG, 5400 Baden (CH)
(72) Inventor: Cole, James, 00380 Helsinki (FI); Ollikainen, Kimmo, 00380 Helsinki (FI); Kauko, Juha, 00380 Helsinki (FI); Pekkarinen, Jenni, 00380 Helsinki (FI); Aikio, Henrik, 00380 Helsinki (FI)
(74) Representative: Kolster Oy Ab

(57) **Abstract**

The represent invention relates to a cover arrangement (2) for an electronic module (4) comprising a housing (8) provided on the module (4) in use and a cover (10) selectively attachable to the housing (8) to provide an at least partially enclosed volume (13) between the cover (10) and housing (8) when the cover (10) is attached to the housing (8). An attachment formation (14,18) is provided on one or both of cover (10) and housing (8) configured to provide the selective attachment therebetween, where the attachment formation comprises two or more attachment points (18) such that the cover (10) may be attached to the housing (8) in two or more positions to define two or more different volumes between the housing (8) and the cover (10) accordingly.

## Description

The present disclosure relates to a cover arrangement, in particular, but not limited to, a cover arrangement for an electronic control module for an electric motor.

### Background of the Invention

Cover arrangements may be used to cover a portion of a housing of control module. In some cases, additional modules may be placed onto the control module. In order to cover/protect the additional module, a different sized cover must be used to accommodate the additional module. This requires different size covers, which in turn requires additional manufacturing processes and costs.

The present disclosure aims to overcome or ameliorate one or more problems of the prior art systems.

### Statement of Invention

According to first aspect there is provided: a cover arrangement for an electronic module comprising: a housing provided on the module in use; a cover selectively attachable to the housing to provide an at least partially enclosed volume between the cover and housing when the cover is attached to the housing; an attachment formation provided on one or both of cover and housing configured to provide the selective attachment therebetween, where the attachment formation comprises two or more attachment points such that the cover may be attached to the housing in two or more positions to define two or more different volumes between the housing and the cover accordingly.

The enclosed volume may be configured to accommodate one or more removable module configured to be operatively connected to the electronics module. A plurality of modules may be provided. The modules may be stacked (i.e. one on top of the other).

A first attachment formation may be provided on one of the cover and the housing and a second formation is provided on the other of the cover and the housing. The first and second attachment formation may be engageable to provide the attachment formation. The attachment points may be discrete. The cover may be fixed at two or more discrete positions.

The cover and/or the housing are flexible to provide engagement/disengagement for the first and second attachment formation. The cover and/or the housing may comprise a flexible polymer. The cover and/or the housing may comprise flexible side walls.

The cover arrangement may comprise a grip portion provided on either of the cover and/or housing to allow the user to provide said flexion to engage/disengage the first and second attachment formation. The grip portion may be provided near or adjacent the first and/or second attachment formation. The grip portion may comprise a plurality of raised ridges or ribs. The grip portion may be provided a first end of the cover/housing. The grip portion may be provided on the side walls of the cover and/or housing.

The first formation may comprise a latch, wedge, ratchet, or angled surface. The second attachment formation may comprise a recess configured to received said latch or wedge. The attachment formation may provide a snap fit. The first formation may allow disengagement from a recess in direction, but prevent disengagement from the recess in a different (e.g. opposing) direction.

The multiple attachment points may be provided by multiple spaced recesses. The recesses may be spaced by a direction perpendicular away from the electronics module and/or a base of the housing. The recesses may be spaced along the height axis of the side walls of the housing/cover. The recesses may be rectangular. The second attachment formation may provide a close fit with the first attachment formation. Attachment points may be provided on two or more sides of the cover/housing.

The cover and/or housing may comprise one or more ridge or rib. The ridge/rib may provide structural rigidity. The ridge/rib may provide suitable flexibility of the cover/housing to ensure operation of the attachment formation. The ridge/rib may be provided adjacent the first and/or second attachment formation.

The cover arrangement may comprise a guiding formation. The guiding formation may be provided on either of the cover or the housing. The guiding formation may be configured to align first attachment formation with the second attachment formation. The guiding formation may comprise a curved or angled surface. The curved/angled surface may face a second end of the cover/housing. The guiding formation may be provided adjacent the attachment formation (e.g. adjacent the recess). The guiding formation may be fixed to a side wall of the cover/housing. The guiding formation may be configured to prevent relative movement between the cover and the housing in one or more direction (e.g. toward/away from the ends of the cover/housing).

One of the housing and cover may comprise a cut-out or recess. The guiding formation may be configured to be received within the cut-out of recess. The cut-out may be provided in a side wall of the cover/housing. The cut-out or recess may be elongate. The cut-out or recess may be provided near or adjacent the attachment formation (e.g. the aperture/recess).

The cover arrangement may comprise a retaining formation. The retaining formation may be configured to provide an interlocking formation between the cover and housing. The retaining formation is spaced from the attachment formation. The retaining formation may be provided at the second end of the housing/cover.

The retaining formation may comprise a first retaining formation on one of the cover and the housing, and second retaining formation on the other of the cover and the housing. The first retaining formation may comprise a protrusion and the second retaining formation comprises a recess configured to receive the protrusion.

Multiple retaining formations may be provided. Multiple retaining formations may be provided such that the cover is retained via a retaining position in multiple positions that correspond to at least two positions provided by the attachment formation. The second retaining formations are spaced by the same spacing as the second attachment formations. Retaining formations may be provided on two or more sides of the housing/cover. The retaining formations may be spaced by a direction perpendicular away from the electronics module and/or a base of the housing. The retaining formations may be spaced along the height axis of the side walls of the housing/cover. The retaining formations may be provided in two or more corners of the housing/cover.

One of the housing and the cover may be received within the other of the housing and the cover. The housing and cover may comprise respective side walls. The respective side walls may be configured to at least partially overlap and define said enclosed volume. The first and second attachment formations may be provided on the side walls. The walls may at least partially overlap in each of the positions. One of the housing and the cover may comprise a side wall having a recess configured to receive a side wall on the other of the housing and the cover. The side walls may be substantially planar. The housing and/or cover may be cuboid.

The two or more attachment points may be linearly spaced from one another such that the cover can be placed in linearly separated positions (i.e. such that the spaced positions may be spaced by a direction perpendicular away from the electronics module and/or a base of the housing).

The housing and/or the cover may comprise an open end at one end thereof. The housing and/or the cover may comprise an open end at two ends thereof. The housing and/or the cover may be U-shaped in cross-sectional profile.

An electrical or communication interface may be provided within the enclosed volume. The electrical or communication interface may comprise a plug and/or socket. An electrical or communication interface may be configured to communicate with an additional module in use.

The cover may comprise branding or insignia.

According to a further aspect, there is provided: an electronics control module comprising the cover arrangement of the first aspect. The electronics modules may be for (i.e. configured to) controlling an electric motor.

The electronics control module may comprise an additional electronics module removably mounted to electronics module and provided in the enclosed space between the housing and the cover.

Any aspect of the invention may be combined with any other aspect of the invention where practicable.

### Description

Embodiments of the present invention are described below, by way of example only, with reference to the accompanying drawings:
**Figure 1** shows a perspective view of a cover arrangement;

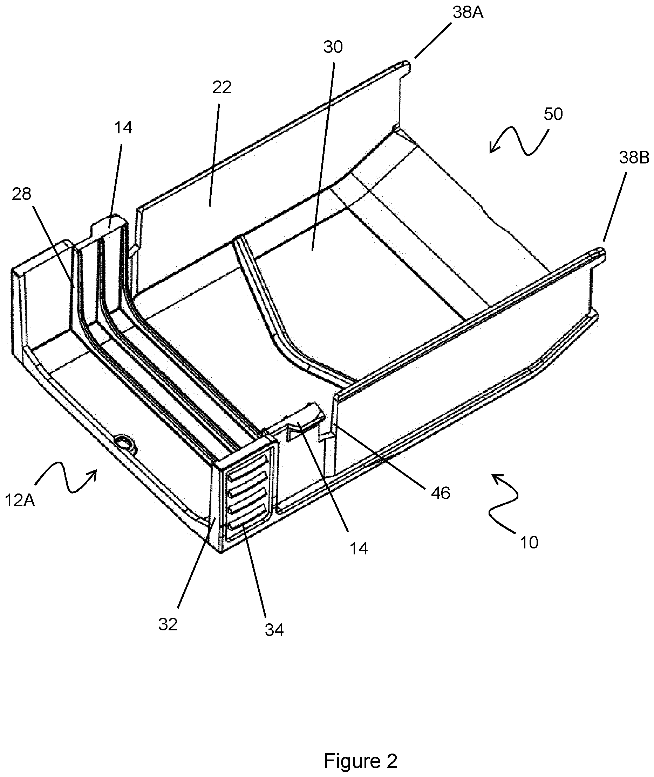

**Figure 2** shows a perspective view of a cover;
**Figures 3-5** shows a sectional side view of a first closing sequence;
**Figures 6 and 7** show a perspective view of a second closing sequence;
**Figures 8 and 9** show a perspective view of the first closing sequence;
Figures 10A-C show perspective view of three examples of the cover arrangement on a respective modules.

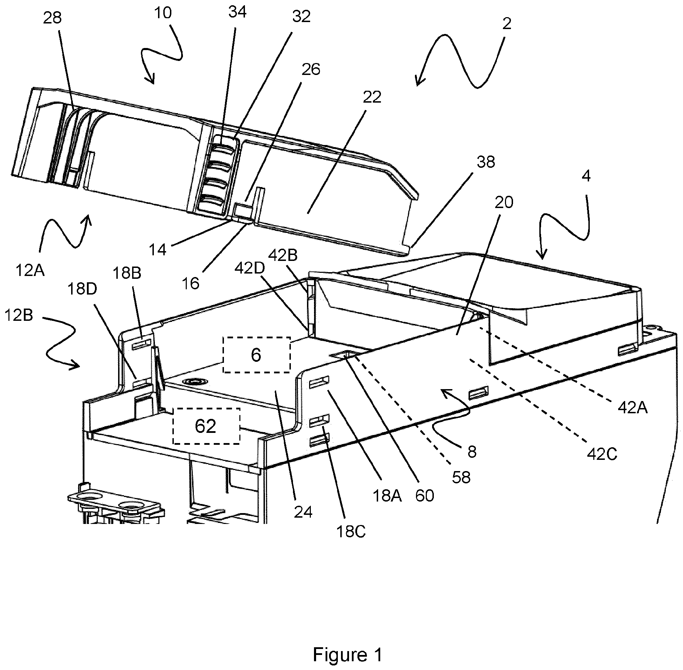

A cover arrangement 2 is shown in figure 1. The cover arrangement 2 is provided on an electronics module 4. The electronics module 4 is typically configured to control one or more electrical device or system. In the present embodiment, the electronics module 4 is configured to control an electric motor (not shown). The electric motor may be provided in any suitable apparatus or industrial environment. For example, the electric motor may be provided in one or more of: a conveying system; a robotic system; a crane system; an actuation system etc. The electronics module 4 is configured to provide power and/or control the electric motor (e.g. control speed, torque, power output, or operating state thereof). The electronics module 6 may comprise a communication interface for communication with the motor and/or other systems.

The electronics module 4 may be provided as a bank or array of said modules. The electronics module 4 may be wall mounted. The electronic module may comprise a generally flat/planar structure to allow adjacent placement of the modules (i.e. in a side-by-side arrangement).

The electronics module 4 may comprise additional modules 6. The additional modules 6 may provide additional functionality of the system. For example, the modules 6 may provide additional switches, measuring/feedback systems, or safety system. The module(s) 6 are removable/detachable from the electronics module 4 to provide a modular system. Connectors or other communication interfaces may be provided to allow the additional modules 6 to communicate with the electronics module 4.

The cover arrangement 2 comprises a housing 8. The housing 8 is configured to contain one or more of the additional modules 6. A cover 10 is configured to be attached to the housing 8. The cover 10 is configured to be place over the additional module 6 in use. The housing 8 and cover 10 therefore collectively provide an enclosure for the additional module 6. The module 6 may comprise a corresponding shape to the cover arrangement 2 and/or provide a close fit therewith. This helps to protect the additional module 6 from damage or contamination etc. The additional module 6 is typically only partially enclosed. For example, this allows access to the additional module 6. First ends 12A,B of the cover 10 and housing 8 respectively are open to allow access to the volume 13 between the cover 10 and the housing 8. The volume is generally cuboid in shape.

The cover 10 is removably attached to the housing 8. This allows installation, removal or access to the additional module 6. The cover 10 is completely separable from the housing 8. The cover 10 is attached to the housing 8 via an attachment formation. The attachment formation comprises a protrusion 14 provided on the cover 10. The protrusion 14 comprises a wedge shape or tapered surface 16. The tapered surface 16 faces the housing 8 in use. The protrusion is configured to be received within an aperture 18 in the housing 8. The tapered shape allows the protrusion 14 to pass over first aperture 18 as the cover 10 and housing 8 are united, but prevents separation thereof. The protrusion 14 thus provides a ratchet type arrangement and/or snap fit.

The aperture 18 provides a close fit with the protrusion 14 to help prevent undesired movement therebetween. The cover 10 is therefore fixed in place. In the present embodiment, the aperture 18 is a through-hole. However, it can be appreciated that in other embodiments, a blind hole, ledge, groove or ridge may be provided to define an effective recess. Apertures 18 are provided are provided on respective side walls 20 of the housing. Protrusions 14 are provided on respective side walls 22 of the cover in corresponding positions.

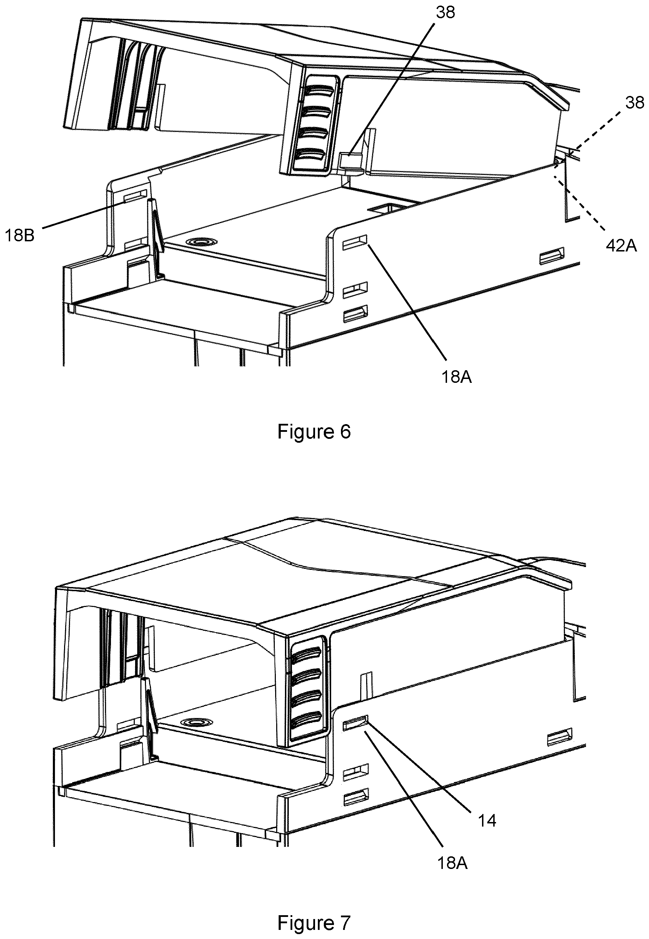

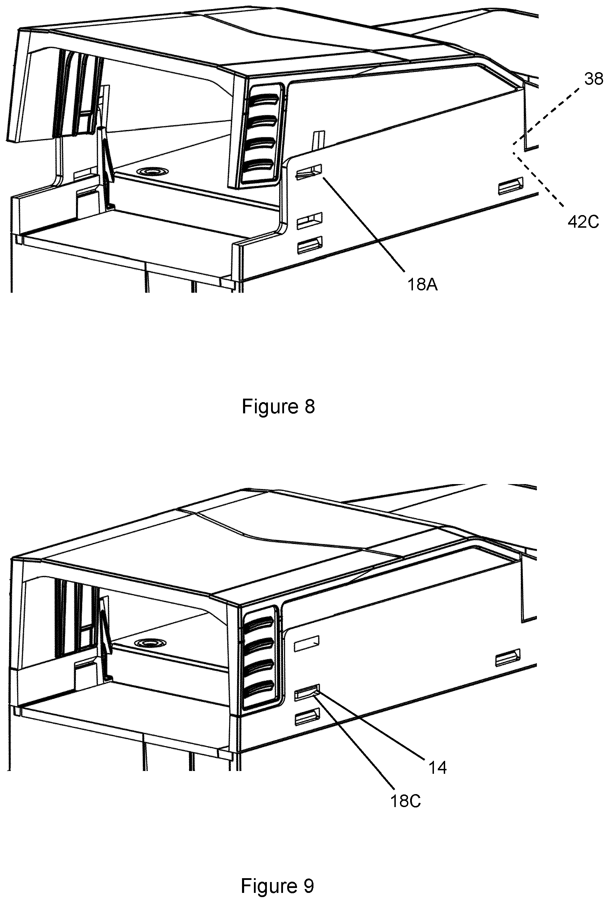

One set of apertures 18A,B are provided at relatively distal position from a base 24 of the housing relative to a second set of apertures 18C,D (i.e. a different positions along the height of the side walls 20). This allows the cover 10 to be attached to the housing 8 at plurality of attachment points. As best seen in figures 7 and 9, this allows the cover 10 and housing 8 to defines a plurality of different volumes enclosed therebetween. This allows one or more additional modules 6 to the attached to the electronic module 4 using a single cover arrangement 2. In the present embodiment, two attachment points (i.e. spaced apertures 18) are provided, however, it can be appreciated that any number of attachment points may be provided, thus allowing a corresponding number of enclosed volumes accordingly. For example, a series of recesses or grooves (e.g. 5 or 10 or more) may be provided for engagement with the protrusion 14. This may allow fine adjustment of the position of the cover 10. The cover 10 may be fixed at discrete positions.

The protrusion 14 may comprises of reinforced or increase thickness portion 26 where mounted to the cover wall 22. Ribs 28 are provided on an internal surface of the cover 10. The ribs 28 extend along the side walls 22 and across the face 30 of the cover. The ribs 28 extend between the protrusions 14. The ribs 28 are generally u-shaped. In the present embodiment, three ribs 28 are provided, however, a single rib or any number of ribs 28 may be provided as necessary. Both the reinforced portion 26 and the ribs 28 increase rigidity of the cover 10, thereby helping to prevent unintentional disengagement of the protrusion 14 from the aperture 18.

The cover 10 and/or the side walls 22 thereof are flexible. This allows the user to disengage the protrusion 14 from the aperture 18 my flexing the side wall 22 inward. The flexibility of the cover 10/side wall 22 is tuned to ensure that the cover 10 can be removed, whilst ensuring secure retention thereof. A grip 32 is provided to allow the user to grip the cover 10 to provide said flexion. The grip 32is provided at the end 12A of the cover 10. The grip 32 is provided near or adjacent the protrusion 14. This allows close control of the position of the protrusion 14. The grip 32 comprises a plurality of ridges or grooves 34.

A retaining formation is provided to help retain the second end 36 of the cover 10 to the housing 8. A protrusion 38 is provided at the second end 36 of the cover 10. The protrusion 38 is provided at an end edge 40 of the side wall 22 (i.e. the edge distal the face 30). The protrusion 38 is configured to be received within a recess 42 in the housing 8. The recess 42 is shaped to receive the protrusion 38. The recess 42 and protrusion 38 form an interlocking relationship. Respective protrusions 38A,B are provided on each side of the cover 10. The protrusion 38 and the recess 42 comprise a trapezoidal shape (e.g. a right angle trapezoid). This may help to guide the protrusion 38 into place. In other embodiments, the protrusion 38 and the recess 42 comprise a curved, rectangular, or other suitable shape.

Recesses 42A-D are provided to receive the protrusions on both sides of the housing, and in both attachment positions. The recesses 42A,C and 42B,D are provided in respective corners of the housing 8. The protrusions 38A,B and 42C,D are thus spaced by the same dimension as the apertures 18A,B and 18C,D respectively. Where more than two apertures 18 are provided, then a corresponding number of the recesses 42 are provided. The retaining formations and attachment formations are arranged such that cover 10 is linearly movable between the first and second attachment points (i.e. there is no relative rotation of the cover 10 relative to the housing 8). The apertures 18 and/or the recesses 42 are spaced in the direction perpendicular to the base 24 of the housing. The cover 10 therefore moves in a direction perpendicular to the base 24 in the different attachment positions. The apertures 18 and/or the recesses 42 are spaced to accommodate the thickness of one or multiple modules.

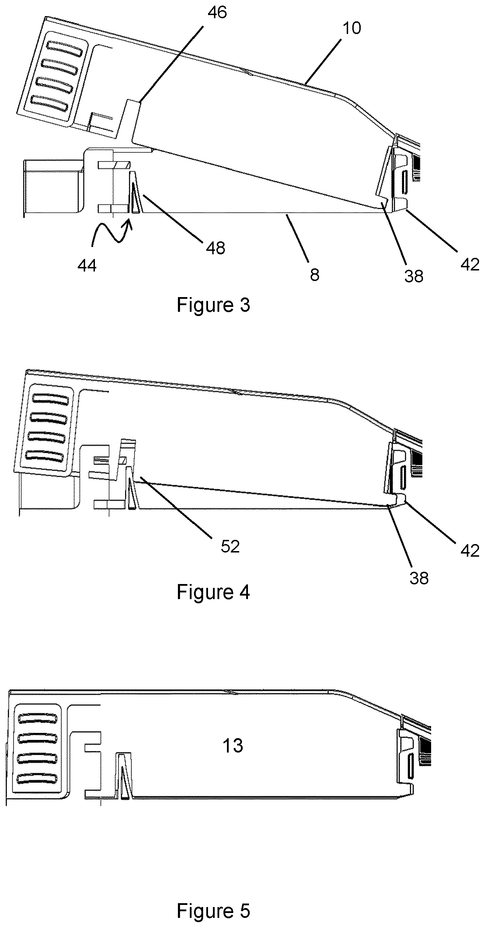

A guiding portion 44 helps to guide and/or locate the cover 10 within the housing 8. As best seen in figures 3-5, the guiding portion 44 comprises a wedge or triangular shaped surface. The guiding portion 44 is provided on the internal side of the housing side wall 20. A cutout 46 is provided on the side wall 22 of the cover 10. The cutout 46 is elongate (i.e. along the height of the wall 22). The guiding portion 44 is configured to be received within the cutout 46. The guiding portion 44 comprise a curved surface 48. The curved surface faces toward the second end 50 of the housing 8. A corner 52 of the side wall 22 adjacent the cutout 46 is configured to engage the curved surface 48, allowing the protrusion 38 to rotate into the recess 42. As best seen in figure 5, the guiding portion 44 also helps to retain the cover 10 in position by preventing end-to-end movement (i.e. toward the right/left hand side of the page).

The side walls 20 are generally thin (e.g. less than 2mm). The guiding formation 44 is fixed to the side walls 20 near or adjacent the aperture 18. This helps to provide rigidity to the side wall 20 at the aperture 18 to ensure the protrusion 14 remains engaged.

The cover 10 and/or housing 8 are generally u-shaped (i.e. in cross section). The side walls 20,22 overlap (in either attachment position). As the internal volume 13 is configured to receive an additional module 6 space is limited. The total thickness of the overlapping side walls 20,22 is less than or equal to 10mm, preferably, less than or equal to 6mm, preferably, less than or equal to 4mm. The cover side walls 22 are received within the housing side wall 20. A rim or lip 54 may be provided at the edge of the side wall 22 of the cover 10 and/or the edge of the side wall 20 of the housing 8. This may provide a loose seal therebetween. The side walls 22 comprises a recessed area 56 to receive the housing side walls 20. The second end 50 of the cover 10 may be open.

The cover 10 and/or housing 8 comprise a polymeric material. The cover 10 and/or housing 8 comprise a single piece (i.e. integral) moulding. For example, the cover 10 and/or housing 8 may be formed using injection moulding.

A communication interface 58 is provided within the housing. The communication interface 58 is configured to provide communication between the electronics module 4 and the additional module 6, where provided. The communication interface may comprise a plug and/or socket type arrangement.

The housing 8 comprises an aperture 60 to allow access to the communication interface 58. The aperture 60 is provided in the base 24. It can be appreciated that any number of interfaces 58 may be provided as required.

Electrical interfaces 62 (shown schematically) are provided within the internal volume 13. The electrical interfaces may provide connectors to allow electrical connection to an external component (e.g. a motor). The open ends 12A,B of the cover/housing allow access to the interfaces 62.

In some embodiments, the attachment formation protrusion 14 may be provided on the housing 8 and the aperture 18 on the cover 10. The housing 8 may then be received within cover 10, and the housing 8 may be flexed to disengage the attachment formation. Similarly, the protrusion 38 of the retaining formation may be provided on the housing 8 and the recess 42 on the cover 10. Branding, identification markings or like may be provided onto the cover 10.

### Operation of the arrangement

Operation of the cover arrangement is first described with reference to figures 6 and 7. In this example, one or more modules (not shown) are mounted within the housing 8. The cover is then attached by first inserting the protrusions 38 into recesses 42A,B. The first end 12A is then rotated such that the protrusions 14A, B snap into position within the respective apertures 18A,B. The latch/ratchet shape of the protrusion ensures the cover 10 remains locked in place

In a second example shown in figures 8 and 9, either no additional modules (or relatively small number thereof) are mounted within the housing 8. Attaching the cover 10 is similar as previously described. In this example, the protrusions 38 are insert into recesses 42A,B. The guiding portion 44 ensures the protrusions 38 guided into the recesses 42A,B. The cover 10 is rotated such that the protrusions 14A,B pass over the first set of apertures 18A,B and snap into the second set of apertures 18C,D.

In order to remove the cover 10 in either embodiment, the grip 32 are pushed together, disengaging the protrusions 14 from the apertures 18. The retaining formation protrusions 38 are then withdrawn from the recesses 42 to fully disengage the cover 10.

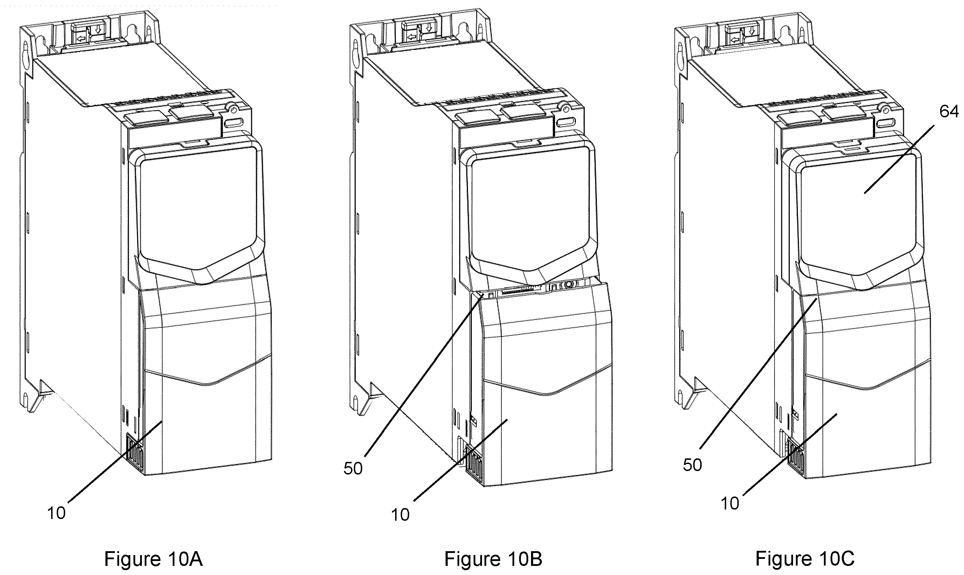

Different configurations of the cover arrangement 2 are shown in figures 10A-C. In figure 10A, the cover 10 is placed in the lowermost position. In this position, zero or one additional module 6 may be provided. In figure 10B, one or more additional modules 6 are provided within the cover 10, and so the cover 10 is mounted in the upper attachment position. The open second end 50 of the cover 10 is exposed. In figure 10C, the cover 10 is provided as figure 10B. In an additional module 64 is provided adjacent the cover 10. The additional module 64 obscures the second end 50 of the cover 10.

The present disclosure provides a universal solution to allow a one or more additional module to be installed on a control unit. Therefore, a single cover may be used with a plurality of different modular configurations without the need for different sized/shaped covers. This reduces manufacturing cost and increases manufacturing simplicity, as multiple tooling etc. is not required. The end user is not required to determine which specific cover is required, and can simply adjust the cover position as required.

## Claims

1. A cover arrangement (2) for an electronic module (4) comprising:
a housing (8) provided on the module (4) in use;
a cover (10) selectively attachable to the housing (8) to provide an at least partially enclosed volume (13) between the cover (10) and housing (8) when the cover (10) is attached to the housing (8);
an attachment formation (14,18) provided on one or both of cover (10) and housing (8) configured to provide the selective attachment therebetween, where the attachment formation comprises two or more attachment points (18) such that the cover (10) may be attached to the housing (8) in two or more positions to define two or more different volumes between the housing (8) and the cover (10) accordingly.

2. A cover arrangement according to claim 1, where a first attachment formation (14) is provided on one of the cover (10) and the housing (8) and a second formation (18) is provided on the other of the cover (10) and the housing (8), the first and second attachment formation engageable to provide the attachment formation (14,18).

3. A cover arrangement according to claim 2, where the cover (10) and/or the housing (8) are flexible to provide engagement/disengagement for the first (14) and second (18) attachment formation.

4. A cover arrangement according to claim 1 or 2, comprising a grip portion (32) provided on either of the cover (10) and/or housing (8) to allow the user to provide said flexion to engage/disengage the first (14) and second (18) attachment formation

5. A cover arrangement according to any of claims 2-4, where the first formation (14) comprises latch or wedge and the second attachment formation (18) comprises a recess configured to received said latch or wedge.

6. A cover arrangement according to claim 5, where the multiple attachment points are provided by multiple spaced recesses (18A-D).

7. A cover arrangement according to any of claims 2-6, comprising a guiding formation (44) configured to align first attachment formation (14) with the second attachment formation (18).

8. A cover arrangement according to any preceding claim, comprising a retaining formation (38,42), the retaining formation (38,42) configured to provide an interlocking formation between the cover (10) and housing (8), and where the retaining formation (38,42) is spaced from the attachment formation (14,18).

9. A cover arrangement according to claim 8, where multiple retaining formations (42A-D) are provided such that the cover is retained via a retaining position in multiple positions that correspond to at least two positions provided by the attachment formation (14,18).

10. A cover arrangement according to any preceding claim, where the housing (8) and cover (10) comprise respective side walls (20,22), the respective side walls (20,22) configured to at least partially overlap and define said enclosed volume (13), and where the first and second attachment (14,18) formations are provided on the side walls (20,22).

11. A cover arrangement according to claim 10, where the side walls (20,22) at least partially overlap in each of the attachment positions.

12. A cover arrangement according to any preceding claim, where the two or more attachment points (18A-D) are linearly spaced from one another such that the cover can be placed in linearly separated positions.

13. A cover arrangement according to any preceding claim, where an electrical or communication interface (62,58) is provided within the enclosed volume (13).

14. An electronics control module (4) for controlling an electric motor comprising the cover arrangement of any preceding claim.

15. An electronics control module according to claim 14, comprising an additional electronics module (6) removably mounted to electronics module (4) and provided in the enclosed space (14) between the housing (8) and the cover (10).
